# EUROPEAN PATENT SPECIFICATION

(11) **EP 3 943 548 B1**
(45) Date of publication and mention of the grant of the patent: **10.01.2024**
(21) Application number: 19920384.5
(22) Date of filing: 08.04.2019
(51) Int. Cl.: C08L 63/00, C08L 79/04

(54) **RESIN COMPOSITION, PREPREG CONTAINING SAME, AND LAMINATE BOARD AND PRINTED CIRCUIT BOARD**
HARZZUSAMMENSETZUNG, PREPREG DAMIT, LAMINATPLATTE UND LEITERPLATTE
COMPOSITION DE RÉSINE, PRÉIMPRÉGNÉ LA CONTENANT, ET CARTE STRATIFIÉE ET CARTE DE CIRCUIT IMPRIMÉ

(30) Priority: 18.03.2019 CN 201910205606
(43) Date of publication of application: 26.01.2022
(73) Proprietor: Shengyi Technology Co., Ltd., Guangdong 523808 (CN)
(72) Inventor: HE, Liexiang, Guangdong 523808 (CN); ZENG, Yaode, Guangdong 523808 (CN); YANG, Zhongqiang, Guangdong 523808 (CN); YANG, Yu, Guangdong 523808 (CN); PAN, Hualin, Guangdong 523808 (CN); XU, Yongjing, Guangdong 523808 (CN)
(74) Representative: Gill Jennings & Every LLP
(86) International application number: PCT/CN2019/081744
(87) International publication number: WO 2020/186572

(56) References cited:
- CN-A- 102 020 830
- US-A1- 2018 326 708

## Description

### Cross references to related applications

The present disclosure claims the priority of Chinese Patent Application No. 201910205606.1 filed on March 18, 2019.

### Technical field

The present disclosure belongs to the technical field of printed circuit boards, and in particular relates to a resin composition, as well as a prepreg, a laminate and a printed circuit board containing the same.

### Background art

In recent years, information communication equipment has become more capable, more functional, and been able to work in the network. In order to transmit and process large-capacity information at high speed, the operating signal tends to be high-frequency. At the same time, in order to meet the development requirements of various electronic products, circuit boards are developing in the direction of more layers and higher wiring density. This requires the substrate material not only to have a good dielectric constant and a good dielectric loss factor to meet the needs of high-frequency signal transmission, but also to have good heat resistance to meet the reliability requirements of multilayer printed circuit boards. In particular, the substrate material needs to have a coefficient of thermal expansion as low as possible.

Resin prepregs are usually used as substrate materials in printed circuit boards. For this reason, some resin compositions have been developed, wherein cyanate esters and active esters are used as a composite curing agent to cure biphenyl-type novolac epoxy resin, aralkylene epoxy resin or naphthol epoxy resin.

CN102020830A discloses compositions comprising halogen-free epoxy resin, reactive polyphosphonate, and cyanate resin,
However, the coefficient of thermal expansion (CTE) of the above resin compositions still needs to be improved.

### Disclosure of the invention

In one aspect, the present disclosure provides a resin composition, comprising:
48-54 parts by weight of a halogen-free epoxy resin,
16-31 parts by weight of a compound represented by Formula (I), 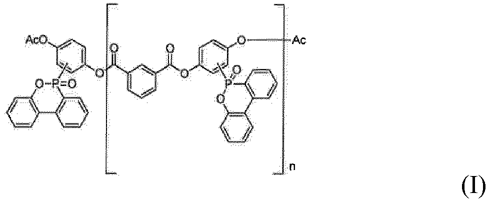
wherein n is 2-15; Ac represents an acetyl group; and
15-32 parts by weight of a cyanate ester resin.

Optionally, the halogen-free epoxy resin is selected from the group consisting of a biphenol novolac epoxy resin, a DCPD novolac epoxy resin, an alkylene novolac epoxy resin, a bisphenol A novolac epoxy resin, a bisphenol AP epoxy resin, a bisphenol TMC epoxy resin, and combinations thereof.

Optionally, the resin composition comprises 16-22 parts by weight of the compound represented by Formula (I), and 25-32 parts by weight of the cyanate ester resin. Optionally, the cyanate ester resin is selected from the group consisting of a bisphenol A cyanate ester resin, a bisphenol F cyanate ester resin, a dicyclopentadiene cyanate ester resin, a phenol novolac cyanate ester resin, and combinations thereof.

Optionally, the resin composition further comprises a curing accelerator.

Optionally, the resin composition further comprises a halogen-free flame retardant.

Optionally, the resin composition further comprises a filler.

In another aspect, the present disclosure provides a prepreg obtained by impregnating or coating a reinforcing material with the resin composition above and semi-curing the same.

In another aspect, the present disclosure provides a laminate comprising at least one sheet of the prepreg above.

In another aspect, the present disclosure provides a printed circuit board comprising at least one sheet of the prepreg or the laminate above.

### Embodiments

The object of the present disclosure is to provide a resin composition. The prepregs, laminates and printed circuit boards prepared by using the resin composition have a low coefficient of thermal expansion.

The inventors of the present disclosure unexpectedly found that an epoxy resin system with a low coefficient of thermal expansion can be obtained by combining a halogen-free epoxy resin with a compound represented by Formula (I) instead of an active ester resin together with a cyanate ester as a composite curing agent.

The present disclosure discloses a resin composition comprising:
48-54 parts by weight of a halogen-free epoxy resin,
16-31 parts by weight of a compound represented by Formula (I), 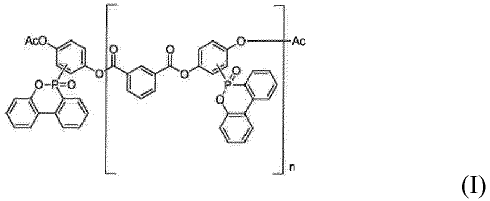
wherein n is 2-15; Ac represents an acetyl group; and
15-32 parts by weight of a cyanate ester resin.

In the present disclosure, the above-mentioned resin composition is obtained by using the mutual coordination and mutual synergistic promotion effect between the above three essential components. The prepregs, laminates and printed circuit boards prepared from the resin composition have a low coefficient of thermal expansion.

The halogen-free epoxy resin component is a halogen-free epoxy resin. The present disclosure does not specifically limit the type of the halogen-free epoxy resin.

The halogen-free epoxy resin is present in an amount of 48-54 parts by weight, e.g. 48, 49, 50, 51, 53 or 54 parts by weight.

Preferably, the halogen-free epoxy resin is selected from the group consisting of a biphenol novolac epoxy resin, a DCPD novolac epoxy resin, an alkylene novolac epoxy resin, a bisphenol A novolac epoxy resin, a bisphenol AP epoxy resin, a bisphenol TMC epoxy resin, and combinations thereof. The advantages of these halogen-free epoxy resins lie in low coefficient of thermal expansion.

Preferably, the compound represented by Formula (I) may be present in an amount of 16-22 parts by weight, e.g. 16, 18, 20 or 22 parts by weight; the cyanate ester resin may be present in an amount of 25-32 parts by weight, e.g. 25, 26, 28, 30 or 32 parts by weight. The selection of the above-mentioned components can well decrease the coefficient of thermal expansion of the halogen-free epoxy resin composition.

The polymerization degree n of the compound represented by Formula (I) is 2-15, and n may be 3, 7, 11, or 15, for example. In the present disclosure, n in the compound represented by Formula (I) in the composition may not be an integer, which represents the average polymerization degree of the compound represented by Formula (I). For example, when half of the compound represented by Formula (I) in the composition has 3 repeating units, and the other half has 4 repeating units, it can be considered that n=3.5. When the average polymerization degree is less than 2, the composition has poor thermal properties after curing. When the average polymerization degree is greater than 15, the composition has poor wettability, which affects the performances of the laminate or printed circuit board. The number average molecular weight of the compound represented by Formula (I) is about 1300 to 7800 accordingly.

Preferably, the cyanate ester resin is selected from the group consisting of a bisphenol A cyanate ester resin, a bisphenol F cyanate ester resin, a dicyclopentadiene cyanate ester resin, a phenol novolac cyanate ester resin, and combinations thereof. The advantage of these cyanate ester resins lies in that they have a lower coefficient of thermal expansion.

Preferably, the resin composition may further include a curing accelerator, which cures the resin and accelerates the curing speed of the resin. Based on the total amount of the halogen-free epoxy resin, the compound represented by Formula (I) and the cyanate ester resin as 100 parts by weight, the curing accelerator is present in an amount of 0.05-1 part by weight, e.g. 0.08, 0.1, 0.15, 0.2, 0.25, 0.3, 0.35, 0.4, 0.45, 0.5, 0.55, 0.60, 0.65, 0.7, 0.75, 0.8, 0.85, 0.9 or 0.95 parts by weight.

Preferably, the curing accelerator is selected from the group consisting of zinc isooctanoate, 4-dimethylaminopyridine, 2-methylimidazole, 2-ethyl-4-methylimidazole, 2-phenylimidazole, and the combinations thereof.

Preferably, the epoxy resin composition, if necessary, further includes a flame retardant, so that the epoxy resin composition has flame retardant characteristics and meets the requirements of UL94V-0. The flame retardant added as necessary is not particularly limited. Preferably, the flame retardant is a halogen-free flame retardant.

The amount of flame retardant is determined on the basis that the cured product meets the requirement of UL 94V-0 level, and is not particularly limited. Preferably, based on the total amount of the halogen-free epoxy resin, the compound represented by Formula (I) and the cyanate ester resin as 100 parts by weight, the flame retardant is present in an amount of 5-50 parts by weight, such as 5, 10, 15, 25, 30, 35, 40 or 45 parts by weight.

Preferably, the halogen-free flame retardant is selected from the group consisting of: tris(2,6-dimethylphenyl)phosphine,
10-(2,5-dihydroxyphenyl)-9,10-dihydro-9-oxa-10-phosphinphenanthrene-10-oxide,
2,6-bis(2,6-dimethylphenyl)phosphinobenzene,
10-phenyl-9,10-dihydro-9-oxa-10-phosphphenanthrene-10-oxide,
phenoxy-phosphazene compound, zinc borate, nitrogen-phosphorus intumescent type flame retardant, organic polymer halogen-free flame retardant, phosphorus-containing novolac resin, and combinations thereof.

Preferably, the resin composition, if necessary, further contains a filler, which is an organic filler and/or inorganic filler and mainly used to adjust some physical effects of the epoxy resin composition, such as further reducing the coefficient of thermal expansion (CTE) and water absorption and increasing thermal conductivity, etc.

The amount of the filler added is not particularly limited. Preferably, the filler is present in an amount of 100 parts by weight or less, preferably 50 parts by weight or less based on the total amount of the halogen-free epoxy resin, the compound represented by Formula (I) and the cyanate ester resin as 100 parts by weight. The amount of the filler is, for example, 0.5, 1, 5, 10, 15, 20, 25, 30, 35, 40, 45, 50, 55, 60, 65, 70, 75, 80, 85, 90 or 95 parts by weight.

Preferably, the inorganic filler is selected from the group consisting of fused silica, crystalline silica, spherical silica, hollow silica, aluminum hydroxide, alumina, talc powder, aluminum nitride, boron nitride, silicon carbide, barium sulfate, barium titanate, strontium titanate, calcium carbonate, calcium silicate, mica, glass fiber powder, and combinations thereof. The combinations thereof are selected from the group consisting of, for example, a mixture of fused silica and crystalline silica, a mixture of spherical silica and hollow silica, a mixture of aluminum hydroxide and alumina, a mixture of talc powder and aluminum nitride, a mixture of boron nitride and silicon carbide, a mixture of barium sulfate and barium titanate, a mixture of strontium titanate and calcium carbonate, a mixture of calcium silicate, mica and glass fiber powder, a mixture of fused silica, crystalline silica and spherical silica, a mixture of hollow silica, aluminum hydroxide and alumina, a mixture of talc powder, aluminum nitride and boron nitride, a mixture of silicon carbide, barium sulfate and barium titanate, a mixture of strontium titanate, calcium carbonate, calcium silicate, mica and glass fiber powder.

Preferably, the organic filler is selected from the group consisting of polytetrafluoroethylene powder, polyphenylene sulfide, polyethersulfone powder, and combinations thereof. Their combinations are selected from the group consisting of, for example, a mixture of polytetrafluoroethylene powder and polyphenylene sulfide, a mixture of polyethersulfone powder and polytetrafluoroethylene powder, a mixture of polyphenylene sulfide and polyethersulfone powder, a mixture of polytetrafluoroethylene powder, polyphenylene sulfide and polyethersulfone powder.

Preferably, the filler is silica. The median particle size of the filler is 0.1-15 µm, preferably 0.1-10 µm.

The expression "comprising/comprises" mentioned in the present disclosure means that, in addition to the aforementioned components, it can also contain other components, which impart different characteristics to the resin composition. In addition, the expression "comprising/comprises" mentioned in the present disclosure can also be replaced with a closed expression "being/is (are)" or "consisting/(consists) of'.

For example, the resin composition may further contain various additives. Specific examples include antioxidants, heat stabilizers, antistatic agents, ultraviolet absorbers, pigments, colorants, lubricants, and the like. These various additives can be used alone or in combination.

The conventional production method of the resin composition of the present disclosure comprises: taking a container, putting solid components in first, then adding a liquid solvent, stirring until completely dissolved, adding a liquid resin, a filler, a flame retardant and a curing accelerator, continuing to stir evenly and finally adjusting the solid content of the liquid to 60%-80% with a solvent to make a glue.

The second object of the present disclosure is to provide a prepreg comprising a reinforcing material and the epoxy resin composition as described above attached thereto after impregnation and drying.

Exemplary reinforcing materials are non-woven fabrics and/or other fabrics, such as natural fibers, organic synthetic fibers, and inorganic fibers.

The glue is used to impregnate reinforcing materials such as glass cloth and other fabrics or organic fabrics, and the impregnated reinforcing materials are heated and dried in an oven at 155-170 °C for 5-10 minutes to obtain a prepreg.

The third object of the present disclosure is to provide a laminate comprising at least one sheet of the prepreg as described above.

The fourth object of the present disclosure is to provide a printed circuit board comprising at least one sheet of the prepreg or the laminate as described above.

In the present disclosure, the above-mentioned resin composition is obtained by using the mutual coordination and mutual synergistic promotion effect between the above three essential components. The prepregs, laminates and printed circuit boards prepared from the resin composition of the present disclosure have a low CTE.

The technical solutions of the present disclosure will be further illustrated by specific examples below.

The metal-clad laminate prepared from the resin composition above is tested to measure the CTE. The details are described below in the following examples, wherein the mass parts of organic resin are calculated by mass parts of organic solids.

The materials used in the examples of the present disclosure are as follows.

KES-7695M75: Epoxy resin containing a DCPD structure (available from KOLON).

NC-3000H: Biphenol novolac epoxy resin (available from Nippon Kayaku).

E15-152T: A compound represented by Formula (I) (available from ICL), where n is about 3.0.

HM1100: Phosphonate polymer (available from FRX Polymers)

HPC-8000-65T: Active ester resin (available from Japan DIC).

CE01PS: Bisphenol A cyanate ester resin (available from Yangzhou Tianqi Chemical).

PT60S: Phenolic cyanate ester resin (available from LONZA).

DMAP: curing accelerator, 4-dimethylaminopyridine (available from Guangrong Chemical)

Zinc isooctanoate: Curing accelerator (available from Alfa Aesar)

Coefficient of Thermal Expansion (CTE) was measured by using thermomechanical analyzer (TMA) according to the TMA method specified in IPC-TM-6502.4.24.

### Example 1

54 parts by weight of an epoxy resin KES-7695M75 and 31 parts by weight of a compound represented by Formula (I) E15-152T were added; and an appropriate amount of methylethyl ketone (MEK) and dimethylformamide (DMF) were added and stirred to dissolve completely. 15 parts by weight of a cyanate ester resin CE01PS, a pre-dissolved curing accelerator DMAP and zinc isooctanoate were then added to continue to stir evenly. Finally, the solid content of the liquid was adjusted to 70% with a solvent to make a glue. A glass fiber cloth was impregnated with the above glue and controlled to an appropriate thickness, and then dried to remove the solvent to obtain a prepreg. 6 sheets of the prepared prepregs were superimposed on each other, pressed with a piece of copper foil on both sides of the prepregs, put in a hot press for curing to form an epoxy resin copper clad laminate. The physical property data are shown in Table 1.

### Examples 2-7

The manufacturing processes are the same as that in Example 1, and the formulations and their physical properties are shown in Table 1.

### Comparative Examples 1-7

The manufacturing processes are the same as that in Example 1, and the formulations and its physical properties are shown in Table 1.

**Table 1 Formulations and physical property data of each example**

| Formulation | Substance | Exp. 1 | Exp. 2 | Exp. 3 | Exp. 4 | Exp. 5 | Exp. 6 | Exp. 7 | Com. Exp 1 | Com. Exp 2 | Com. Exp 3 | Com. Exp 4 | Com. Exp 5 | Com. Exp 6 | Com Exp. 7 |
|---|---|---|---|---|---|---|---|---|---|---|---|---|---|---|---|
| Biphenyl epoxy resin | NC-3000H | | 54 | 53 | 53 | 48 | 52 | 52 | 69 | 74 | 80 | | 54 | | 54 |
| DCPD type epoxy resin | KES-7695M75 | 54 | | | | | | | | | | 54 | | 54 | |
| The Compound represented by Formula (1) | E15-152T | 31 | 31 | 25 | 22 | 22 | 16 | 16 | 16 | 16 | 10 | | | | |
| HM1100 | | | | | | | | | | | | | | 31 | 31 |
| Active ester resin | HPC-8000-65T | | | | | | | | | | | 31 | 31 | | |
| Cyanate ester resin | CE01PS | 15 | 15 | 22 | 25 | 30 | 32 | | 15 | 10 | 10 | 15 | 15 | 15 | 15 |
| | PT60S | | | | | | | 32 | | | | | | | |
| Curing accelerator | DMAP | q.s. | q. s. | q. s. | q. s. | q. s. | q. s. | q. s. | q. s. | q. s. | q. s. | q. s. | q. s. | q. s. | q.s. |
| | Zinc isooctanoate | q.s. | q. s. | q. s. | q. s. | q. s. | q. s. | q. s. | q.s. | q. s. | q. s. | q. s. | q. s. | q. s. | q.s. |
| Performance | CTE | 2.6 % | 2.7 % | 2.6 % | 2.5 % | 2.4 % | 2.3 % | 2.1 % | 3.3 % | 3.4 % | 3.6 % | 3.0 % | 3.2 % | 3.6 % | 3.7 % |

| | | | | | | | | | | | | | | | |
|---|---|---|---|---|---|---|---|---|---|---|---|---|---|---|---|
| Note: all the components in the table are calculated by parts by weight of solid components. | | | | | | | | | | | | | | | |

By comparing with Comparative Examples 1-3, it can be seen that the contents of each component in Examples 1-7 fall within the scope defined by the present disclosure. The epoxy resin, the cyanate ester and the compound represented by Formula (I) in a specific content ratio have a synergistic effect and have a better coefficient of thermal expansion. The component contents of Examples 4-7 are all within the preferred ranges of the present disclosure, and there is a lower coefficient of thermal expansion than other examples.

Comparative Examples 4-7 which used no compound represented by Formula (I) can also achieve curing and flame retardant effects, but the coefficient of thermal expansion thereof can reach 3.7%.

As described above, the resin composition of the present disclosure provides an epoxy resin having a low CTE and containing cyanate ester. Correspondingly, the prepregs, laminates and printed circuit boards of the present disclosure also have a low CTE.

## Claims

1. A resin composition, comprising:
48-54 parts by weight of a halogen-free epoxy resin,
16-31 parts by weight of a compound represented by Formula (I), 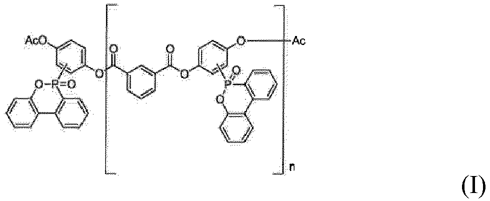
wherein n is 2-15; Ac represents an acetyl group; and
15-32 parts by weight of a cyanate ester resin.

2. The resin composition claimed in claim 1, wherein the halogen-free epoxy resin is selected from the group consisting of a biphenol novolac epoxy resin, a DCPD novolac epoxy resin, an alkylene novolac epoxy resin, a bisphenol A novolac epoxy resin, a bisphenol AP epoxy resin, a bisphenol TMC epoxy resin, and combinations thereof.

3. The resin composition claimed in claim 1, wherein the resin composition comprises 16-22 parts by weight of the compound represented by Formula (I), and 25-32 parts by weight of the cyanate ester resin.

4. The resin composition claimed in claim 1, wherein the cyanate ester resin is selected from the group consisting of a bisphenol A cyanate ester resin, a bisphenol F cyanate ester resin, a dicyclopentadiene cyanate ester resin, a phenol novolac cyanate ester resin, and combinations thereof.

5. The resin composition claimed in claim 1, wherein the resin composition further comprises a curing accelerator.

6. The resin composition claimed in claim 1, wherein the resin composition further comprises a halogen-free flame retardant.

7. The resin composition claimed in claim 1, wherein the resin composition further comprises a filler.

8. A prepreg obtained by impregnating or coating a reinforcing material with the resin composition claimed in claim 1 and semi-curing the same.

9. A laminate comprising at least one sheet of the prepreg claimed in claim 8.

10. A printed circuit board comprising at least one sheet of the prepreg claimed in claim 8, or at least one sheet of the laminate claimed in claim 9.

## Patentansprüche

1. Harzzusammensetzung, umfassend:
48-54 Gewichtsteile eines halogenfreien Epoxidharzes,
16-31 Gewichtsteile einer durch die Formel (I) dargestellten Verbindung, 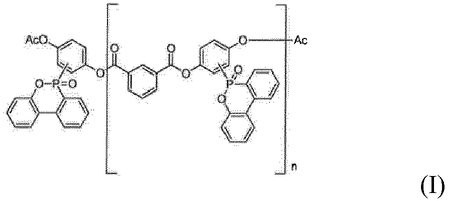
wobei n 2-15 ist; Ac eine Acetylgruppe darstellt; und
15-32 Gewichtsteile eines Cyanatesterharzes.

2. Harzzusammensetzung nach Anspruch 1, wobei das halogenfreie Epoxidharz aus der Gruppe ausgewählt ist, bestehend aus einem Biphenolnovolakepoxidharz, einem DCPD-Novolakepoxidharz, einem Alkylennovolakepoxidharz, einem Bisphenol-A-Novolakepoxidharz, einem Bisphenol-AP-Epoxidharz, einem Bisphenol-TMC-Epoxidharz und Kombinationen davon.

3. Harzzusammensetzung nach Anspruch 1, wobei die Harzzusammensetzung 16-22 Gewichtsteile der durch Formel (I) dargestellten Verbindung und 25-32 Gewichtsteile des Cyanatesterharzes umfasst.

4. Harzzusammensetzung nach Anspruch 1, wobei das Cyanatesterharz aus der Gruppe ausgewählt ist, bestehend aus einem Bisphenol-A-Cyanatesterharz, einem Bisphenol-F-Cyanatesterharz, einem Dicyclopentadiencyanatesterharz, einem Phenolnovolaccyanatesterharz und Kombinationen davon.

5. Harzzusammensetzung nach Anspruch 1, wobei die Harzzusammensetzung ferner einen Härtungsbeschleuniger umfasst.

6. Harzzusammensetzung nach Anspruch 1, wobei die Harzzusammensetzung ferner ein halogenfreies Flammschutzmittel umfasst.

7. Harzzusammensetzung nach Anspruch 1, wobei die Harzzusammensetzung ferner einen Füllstoff umfasst.

8. Prepreg, das durch Imprägnieren oder Beschichten eines Verstärkungsmaterials mit der Harzzusammensetzung nach Anspruch 1 und Halbhärten desselben erhalten wird.

9. Laminat, umfassend wenigstens eine Platte aus dem Prepreg nach Anspruch 8.

10. Gedruckte Leiterplatte, umfassend wenigstens eine Platte des Prepregs nach Anspruch 8 oder wenigstens eine Platte des Laminats nach Anspruch 9.

## Revendications

1. Composition de résine, comprenant :
48-54 parties en poids d'une résine époxy sans halogène,
16-31 parties en poids d'un composé représenté par la Formule (I), 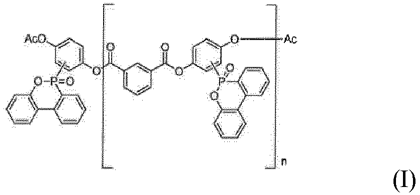
dans laquelle n est 2-15 ;
Ac représente un groupe acétyle ; et
15-32 parties en poids d'une résine d'ester de cyanate.

2. Composition de résine selon la revendication 1, dans laquelle la résine époxy sans halogène est sélectionnée dans le groupe constitué d'une résine époxy novolaque de biphénol, une résine époxy novolaque DCPD, une résine époxy novolaque d'alkylène, une résine époxy novolaque de bisphénol A, une résine époxy de bisphénol AP, une résine époxy de bisphénol TMC, et des combinaisons de ces dernières.

3. Composition de résine selon la revendication 1, dans laquelle la composition de résine comprend 16-22 parties en poids du composé représenté par la Formule (I) et 25-32 parties en poids de la résine d'ester de cyanate.

4. Composition de résine selon la revendication 1, dans laquelle la résine d'ester de cyanate est sélectionnée dans le groupe constitué d'une résine d'ester de cyanate de bisphénol A, une résine d'ester de cyanate de bisphénol F, une résine d'ester de cyanate de dicyclopentadiène, une résine d'ester de cyanate novolaque de phénol, et des combinaisons de ces dernières.

5. Composition de résine selon la revendication 1, dans laquelle la composition de résine comprend en outre un accélérateur de durcissement.

6. Composition de résine selon la revendication 1, dans laquelle la composition de résine comprend en outre un retardateur de flamme sans halogène.

7. Composition de résine selon la revendication 1, dans laquelle la composition de résine comprend en outre une charge.

8. Préimprégné obtenu en imprégnant ou revêtant un matériau de renfort avec la composition de résine selon la revendication 1 et en la semi-durcissant.

9. Stratifié comprenant une ou plusieurs feuilles du préimprégné selon la revendication 8.

10. Carte à circuit imprimé comprenant une ou plusieurs feuilles du préimprégné selon la revendication 8, ou une ou plusieurs feuilles du stratifié selon la revendication 9.
